# EUROPÄISCHE PATENTANMELDUNG

(11) **EP 4 521 647 A1**
(43) Veröffentlichungstag der Anmeldung: **12.03.2025**
(21) Anmeldenummer: 23195414.0
(22) Anmeldetag: 05.09.2023
(51) Int. Cl.: H03M 1/10, H04Q 9/00

(54) **ERKENNEN EINES FEHLERS BEIM ABTASTEN EINES ANALOGSIGNALS**

(71) Anmelder: Siemens Aktiengesellschaft, 80333 München (DE)
(72) Erfinder: Snaidero, Fabian, 91413 Neustadt a.d. Aisch (DE)
(74) Vertreter: Siemens Patent Attorneys

(57) **Zusammenfassung**

Die Erfindung betrifft ein Modul (1) zum Abtasten eines Analogsignals (S) und ein Verfahren zum Erkennen eines Fehlers beim Abtasten des Analogsignals (S). Bei dem Verfahren wird die Fertigstellung jeder Abtastung des Analogsignals (S) einem Prozessor (5) des Moduls (1) durch ein Meldesignal (M) gemeldet. Von dem Prozessor (5) wird zu bezogen auf eine Modulzeit äquidistanten Modulzeitpunkten jeweils ein Prozessorsignal (P) generiert. Einmalig wird eine Referenzzeitdauer gemessen, die ein Zeitabstand zwischen der Generierung eines Prozessorsignals (P) und dem nächsten auf die Generierung des Prozessorsignals (P) folgenden Empfang eines Meldesignals (M) durch den Prozessor (5) ist. Für jedes folgende Prozessorsignal (P) wird eine Signaldifferenzzeitdauer gemessen, die ein Zeitabstand zwischen der Generierung des Prozessorsignals (P) und dem nächsten auf die Generierung des Prozessorsignals (P) folgenden Empfang eines Meldesignals (M) durch den Prozessor (5) ist. Auf einen Fehler wird geschlossen, wenn eine Signaldifferenzzeitdauer um mehr als eine Toleranzzeitdauer von der Referenzzeitdauer abweicht.

## Beschreibung

Die Erfindung betrifft ein Modul zum Abtasten eines Analogsignals und ein Verfahren zum Erkennen eines Fehlers beim Abtasten eines Analogsignals durch ein Modul.

Insbesondere betrifft die Erfindung das Abtasten eines Analogsignals durch ein Modul, dessen Modulzeit wiederholt mit einer Systemzeit synchronisiert wird. Insbesondere in Ethernet-Netzwerken werden Uhren beispielsweise gemäß einem Synchronisierungsprotokoll synchronisiert. Ein derartiges Synchronisierungsprotokoll ist beispielsweise das so genannte Precision Time Protocol (PTP). Bei einer derartigen Synchronisierung werden Synchronisierungstelegramme mit Zeitstempeln über das Netzwerk verschickt, mittels derer Uhren in dem Netzwerk ihre Zeit einander angleichen. Typischerweise ist eine dieser Uhren eine so genannte Master-Uhr, die eine Master-Uhrzeit für so genannte Slave-Uhren vorgibt. Insbesondere eine fehlerhafte oder ausbleibende Synchronisierung der Uhren in dem Netzwerk kann zu Fehlern beim Abtasten des Analogsignals führen.

Der Erfindung liegt die Aufgabe zugrunde, einen Fehler beim Abtasten eines Analogsignals zu erkennen.

Die Aufgabe wird erfindungsgemäß durch ein Verfahren mit den Merkmalen des Anspruchs 1 und ein Modul mit den Merkmalen des Anspruchs 10 gelöst.

Vorteilhafte Ausgestaltungen der Erfindung sind Gegenstand der Unteransprüche.

Das erfindungsgemäße Verfahren zum Erkennen eines Fehlers eines Moduls zur Abtastung eines Analogsignals mit einer vorgegebenen Abtastrate umfasst folgende Schritte:
- die Fertigstellung jeder Abtastung des Analogsignals wird einem Prozessor des Moduls durch ein Meldesignal gemeldet,
- eine Modulzeit wird wiederholt mit einer Systemzeit synchronisiert,
- von dem Prozessor wird zu bezogen auf die Modulzeit äquidistanten Modulzeitpunkten jeweils ein Prozessorsignal generiert, so dass die Differenz je zweier aufeinander folgender Modulzeitpunkte eine konstante Modulzeitdifferenz ist,
- einmalig wird eine Referenzzeitdauer gemessen, die ein Zeitabstand zwischen der Generierung eines Prozessorsignals und dem nächsten auf die Generierung des Prozessorsignals folgenden Empfang eines Meldesignals durch den Prozessor ist,
- für jedes Prozessorsignal, das auf das für die Messung der Referenzzeitdauer verwendete Prozessorsignal folgt, wird eine Signaldifferenzzeitdauer gemessen, die ein Zeitabstand zwischen der Generierung des Prozessorsignals und dem nächsten auf die Generierung des Prozessorsignals folgenden Empfang eines Meldesignals durch den Prozessor ist,
- es wird eine Toleranzzeitdauer festgelegt und
- es wird auf einen Fehler geschlossen, wenn eine gemessene Signaldifferenzzeitdauer um mehr als die festgelegte Toleranzzeitdauer von der Referenzzeitdauer abweicht.

Das erfindungsgemäße Verfahren basiert auf der Idee, Prozessorsignale eines Prozessors des Moduls und die Abtastungen des Analogsignals miteinander in Beziehung zu setzen. Die Prozessorsignale werden von dem Prozessor zu bezogen auf die Modulzeit äquidistanten Modulzeitpunkten erzeugt. Die Prozessorsignale sind somit ein Maß für die Modulzeit. Die Fertigstellung jeder Abtastung des Analogsignals wird dem Prozessor des Moduls durch ein Meldesignal gemeldet. Daher deutet eine Verschiebung der Meldesignale gegenüber den Prozessorsignalen an, dass die Abtastung des Analogsignals nicht mehr konform mit der Modulzeit ist.

Das Verfahren zielt darauf ab, eine derartige Verschiebung der Meldesignale gegenüber den Prozessorsignalen zu erkennen. Zu diesem Zweck sieht das Verfahren vor, einmalig eine Referenzzeitdauer zu messen, die ein Zeitabstand zwischen der Generierung eines Prozessorsignals und dem nächsten auf die Generierung des Prozessorsignals folgenden Empfang eines Meldesignals durch den Prozessor ist. Mit dieser Referenzzeitdauer werden Signaldifferenzzeitdauern verglichen, die wie die Referenzzeitdauer auch jeweils ein Zeitabstand zwischen der Generierung eines Prozessorsignals und dem nächsten auf die Generierung des Prozessorsignals folgenden Empfang eines Meldesignals durch den Prozessor sind. Wenn eine Signaldifferenzzeitdauer wesentlich, das heißt um mehr als eine festgelegte Toleranzzeitdauer, von der Referenzzeitdauer abweicht, wird auf einen Fehler geschlossen.

Das erfindungsgemäße Verfahren ermöglicht vorteilhaft, dass das Modul selbst eine fehlerhafte Abtastung des Analogsignals erkennen kann, da das Verfahren auf der Messung und Auswertung ausschließlich modulinterner Signale, nämlich der Prozessorsignale und der Meldesignale, basiert. Insbesondere erfordert das Verfahren somit keine übergeordnete Steuerungs- oder Überwachungseinheit, um eine fehlerhafte Abtastung zu erkennen.

Bei einer Ausgestaltung des erfindungsgemäßen Verfahrens ist die Modulzeitdifferenz ein Vielfaches des Kehrwerts der Abtastrate.

Die vorgenannte Ausgestaltung des erfindungsgemäßen Verfahrens stellt sicher, dass bei einer fehlerfrei auf die Modulzeit bezogenen Durchführung der Abtastungen des Analogsignals die Signaldifferenzzeitdauer stets denselben Wert, nämlich den Wert der Referenzzeitdauer, hat. Dies ist erforderlich, um jede gemessene Signaldifferenzzeitdauer sinnvoll mit der Referenzzeitdauer vergleichen zu können.

Bei einer weiteren Ausgestaltung des erfindungsgemäßen Verfahrens ist die Toleranzzeitdauer kleiner als die Hälfte des Kehrwerts der Abtastrate.

Die vorgenannte Ausgestaltung des erfindungsgemäßen Verfahrens zielt darauf ab, dass die Toleranzzeitdauer jeweils auf das richtige Meldesignal bezogen wird und nicht auf ein Meldesignal, dass diesem Meldesignal folgt oder vorausgeht.

Bei einer weiteren Ausgestaltung des erfindungsgemäßen Verfahrens wird die Modulzeit unter Verwendung von dem Modul empfangener Synchronisierungsnachrichten gemäß einem Synchronisierungsprotokoll mit der Systemzeit synchronisiert. Beispielsweise wird als Synchronisierungsprotokoll das Precision Time Protocol (PTP) oder das Network Time Protocol (NTP) verwendet.

Die vorgenannte Ausgestaltung des erfindungsgemäßen Verfahrens zielt insbesondere auf den Einsatz des erfindungsgemäßen Verfahrens für ein Modul, das an ein Netzwerk, insbesondere an ein Ethernet-Netzwerk, angebunden ist.

Bei einer weiteren Ausgestaltung des erfindungsgemäßen Verfahrens wird das Analogsignal von einer Abtasteinheit abgetastet, die einen mittels einer Taktnachführungseinheit von der Modulzeit abgeleiteten Taktgeber aufweist.

Die vorgenannte Ausgestaltung des erfindungsgemäßen Verfahrens zielt darauf ab, die Abtastungen des Analogsignals auf die Modulzeit zu beziehen. Zu diesem Zweck wird eine Abtasteinheit verwendet, die einen Taktgeber aufweist, der mittels einer Taktnachführungseinheit auf die Modulzeit bezogen wird.

Bei einer weiteren Ausgestaltung des erfindungsgemäßen Verfahrens wird ein Zeitabstand zwischen dem Empfangen je zweier aufeinander Meldesignale durch den Prozessor erfasst und auf einen Fehler des Moduls geschlossen, wenn einer dieser Zeitabstände größer oder kleiner als ein vorgegebener Zeitschwellenwert ist.

Die vorgenannte Ausgestaltung des erfindungsgemäßen Verfahrens berücksichtigt, dass der Zeitabstand zwischen dem Empfangen je zweier aufeinander folgender Meldesignale durch den Prozessor zeitlich wenigstens annähernd konstant sein sollte. Eine Abweichung dieses Zeitabstands von einem geeignet gewählten Zeitschwellenwert deutet daher ebenfalls auf eine fehlerhafte Abtastung des Analogsignals hin.

Bei einer weiteren Ausgestaltung des erfindungsgemäßen Verfahrens wird eine Reaktion ausgegeben, wenn auf einen Fehler des Moduls geschlossen wird. Als Reaktion wird beispielsweise ein optisches Signal ausgegeben, beispielsweise ein mit einer Leuchtdiode oder mehreren Leuchtdioden erzeugtes Signal. Dadurch kann eine fehlerhafte Abtastung des Analogsignals signalisiert werden.

Ein erfindungsgemäßes Modul zur Abtastung eines Analogsignals mit einer vorgegebenen Abtastrate umfasst
- eine Synchronisierungseinheit, die eingerichtet ist, eine Modulzeit wiederholt mit einer Systemzeit zu synchronisieren,
- einen Prozessor, der eingerichtet ist, zu bezogen auf die Modulzeit äquidistanten Modulzeitpunkten jeweils ein Prozessorsignal zu generieren, so dass die Differenz je zweier aufeinander folgender Modulzeitpunkte eine konstante Modulzeitdifferenz ist,
- eine Abtasteinheit, die einen mittels einer Taktnachführungseinheit von der Modulzeit abgeleiteten Taktgeber aufweist und eingerichtet ist, das Analogsignal gemäß der Abtastrate abzutasten und die Fertigstellung jeder Abtastung des Analogsignals dem Prozessor durch ein Meldesignal zu melden,
- eine Zeitmesseinheit, die eingerichtet ist, für Prozessorsignale jeweils eine Signaldifferenzzeitdauer zu messen, die ein Zeitabstand zwischen der Generierung des Prozessorsignals und dem nächsten auf die Generierung des Prozessorsignals folgenden Empfang eines Meldesignals durch den Prozessor ist, und
- eine Auswerteeinheit, die eingerichtet ist, eine einmalig für ein Prozessorsignal gemessene Signaldifferenzzeitdauer als eine Referenzzeitdauer zu speichern und für jedes Prozessorsignal, das auf das für die Messung der Referenzzeitdauer verwendete Prozessorsignal folgt, die gemessene Signaldifferenzzeitdauer mit der Referenzzeitdauer zu vergleichen und auf einen Fehler des Moduls zu schließen, wenn die gemessene Signaldifferenzzeitdauer um mehr als die Toleranzzeitdauer von der Referenzzeitdauer abweicht.

Ein erfindungsgemäßes Modul ermöglicht die Durchführung des erfindungsgemäßen Verfahrens. Daher entsprechen die Vorteile eines erfindungsgemäßen Moduls den oben genannten Vorteilen des erfindungsgemäßen Verfahrens.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung von Ausführungsbeispielen, die im Zusammenhang mit den Zeichnungen näher erläutert werden. Dabei zeigen:
- FIG 1: eine Signalkette zum Erkennen eines Fehlers beim Abtasten eines Analogsignals,
- FIG 2: ein Blockdiagramm eines Moduls zum Abtasten eines Analogsignals.

Einander entsprechende Teile sind in den Figuren mit denselben Bezugszeichen versehen.

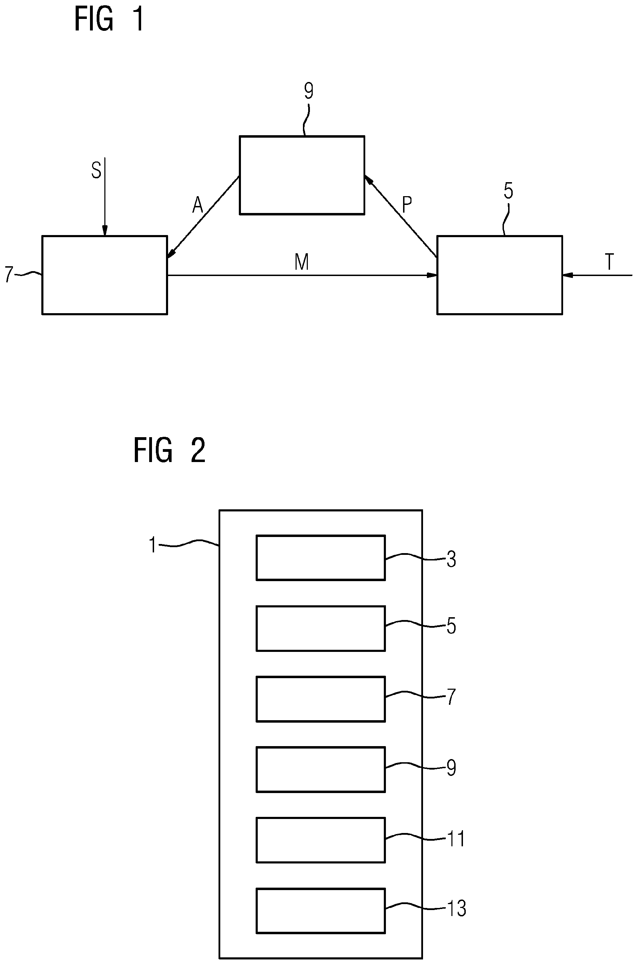

FIG 1 illustriert ein Ausführungsbeispiel des erfindungsgemäßen Verfahrens zum Erkennen eines Fehlers beim Abtasten eines Analogsignals S mit einer vorgegebenen Abtastrate durch ein Modul 1.

FIG 2 zeigt ein Blockdiagramm eines Ausführungsbeispiels des Moduls 1. Das Modul 1 umfasst eine Synchronisierungseinheit 3, einen Prozessor 5, eine Abtasteinheit 7, eine Taktnachführungseinheit 9, eine Zeitmesseinheit 11 und eine Auswerteeinheit 13.

Mit der Synchronisierungseinheit 3 wird eine Modulzeit wiederholt mit einer Systemzeit T synchronisiert. Beispielsweise wird die Modulzeit unter Verwendung von dem Modul 1 empfangener Synchronisierungsnachrichten gemäß einem Synchronisierungsprotokoll mit der Systemzeit T synchronisiert. Als Synchronisierungsprotokoll wird beispielsweise das Precision Time Protocol (PTP) oder das Network Time Protocol (NTP) verwendet.

Von dem Prozessor 5 wird zu bezogen auf die Modulzeit äquidistanten Modulzeitpunkten jeweils ein Prozessorsignal P generiert, so dass die Differenz je zweier aufeinander folgender Modulzeitpunkte eine konstante Modulzeitdifferenz ist. Die Modulzeitdifferenz ist ein Vielfaches des Kehrwerts der Abtastrate.

Von der Taktnachführungseinheit 9 wird ein Abtasttakt A für einen Taktgeber der Abtasteinheit 7 von der Modulzeit abgeleitet. Von der Abtasteinheit 7 wird das Analogsignal S gemäß dem von der Taktnachführungseinheit 9 nachgeführten Abtasttakt A abgetastet. Die Fertigstellung jeder Abtastung des Analogsignals S wird dem Prozessor 5 von der Abtasteinheit 7 durch ein Meldesignal M gemeldet.

Von der Zeitmesseinheit 11 wird einmalig eine Referenzzeitdauer gemessen, die ein Zeitabstand zwischen der Generierung eines Prozessorsignals P und dem nächsten auf die Generierung des Prozessorsignals P folgenden Empfang eines Meldesignals M durch den Prozessor 5 ist. Die Referenzzeitdauer wird beispielsweise nach einem Einschwingen des Systems gemessen, z.B. wenn eine durch ein Synchronisierungsprotokoll bereitgestellte Master-Uhrzeit und eine Slave-Uhrzeit höchstens eine vorgegebene Zeitdifferenz, beispielsweise 50 ns, voneinander abweichen oder eine festgelegte Mindestanzahl von Synchronisierungstelegrammen des Synchronisierungsprotokolls ausgetauscht wurden. Die Referenzzeitdauer wird von der Auswerteeinheit 13 gespeichert.

Anschließend wird von der Zeitmesseinheit 11 für jedes Prozessorsignal P, das auf das für die Messung der Referenzzeitdauer verwendete Prozessorsignal P folgt, eine Signaldifferenzzeitdauer gemessen, die ein Zeitabstand zwischen der Generierung des Prozessorsignals P und dem nächsten auf die Generierung des Prozessorsignals P folgenden Empfang eines Meldesignals M durch den Prozessor 5 ist. Von der Auswerteeinheit 13 wird die gemessene Signaldifferenzzeitdauer mit der Referenzzeitdauer verglichen und auf einen Fehler des Moduls 1 geschlossen, wenn die gemessene Signaldifferenzzeitdauer um mehr als eine festgelegte Toleranzzeitdauer von der Referenzzeitdauer abweicht. Die Toleranzzeitdauer ist beispielsweise kleiner als die Hälfte des Kehrwerts der Abtastrate.

Optional wird von der Zeitmesseinheit 11 zusätzlich ein Zeitabstand zwischen dem Empfangen je zweier aufeinander Meldesignale M durch den Prozessor 5 erfasst und auf einen Fehler des Moduls 1 geschlossen, wenn einer dieser Zeitabstände größer oder kleiner als ein vorgegebener Zeitschwellenwert ist.

Ferner kann eine Reaktion ausgegeben werden, wenn auf einen Fehler des Moduls 1 geschlossen wird. Als Reaktion wird beispielsweise ein optisches Signal ausgegeben, beispielsweise ein mit einer Leuchtdiode oder mehreren Leuchtdioden erzeugtes Signal.

Obwohl die Erfindung im Detail durch bevorzugte Ausführungsbeispiele näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen. Unabhängig vom grammatikalischen Geschlecht eines bestimmten Begriffs sind Personen mit männlicher, weiblicher oder anderer Geschlechteridentität mit umfasst.

## Patentansprüche

1. Verfahren zum Erkennen eines Fehlers eines Moduls (1) zur Abtastung eines Analogsignals (S) mit einer vorgegebenen Abtastrate, wobei
- die Fertigstellung jeder Abtastung des Analogsignals (S) einem Prozessor (5) des Moduls (1) durch ein Meldesignal (M) gemeldet wird,
- eine Modulzeit wiederholt mit einer Systemzeit (T) synchronisiert wird,
- von dem Prozessor (5) zu bezogen auf die Modulzeit äquidistanten Modulzeitpunkten jeweils ein Prozessorsignal (P) generiert wird, so dass die Differenz je zweier aufeinander folgender Modulzeitpunkte eine konstante Modulzeitdifferenz ist,
- einmalig eine Referenzzeitdauer gemessen wird, die ein Zeitabstand zwischen der Generierung eines Prozessorsignals (P) und dem nächsten auf die Generierung des Prozessorsignals (P) folgenden Empfang eines Meldesignals (M) durch den Prozessor (5) ist,
- für jedes Prozessorsignal (P), das auf das für die Messung der Referenzzeitdauer verwendete Prozessorsignal (P) folgt, eine Signaldifferenzzeitdauer gemessen wird, die ein Zeitabstand zwischen der Generierung des Prozessorsignals (P) und dem nächsten auf die Generierung des Prozessorsignals (P) folgenden Empfang eines Meldesignals (M) durch den Prozessor (5) ist,
- eine Toleranzzeitdauer festgelegt wird und
- auf einen Fehler geschlossen wird, wenn eine gemessene Signaldifferenzzeitdauer um mehr als die festgelegte Toleranzzeitdauer von der Referenzzeitdauer abweicht.

2. Verfahren nach Anspruch 1, wobei die Modulzeitdifferenz ein Vielfaches des Kehrwerts der Abtastrate ist.

3. Verfahren nach Anspruch 1 oder 2, wobei die Toleranzzeitdauer kleiner als die Hälfte des Kehrwerts der Abtastrate ist.

4. Verfahren nach einem der vorhergehenden Ansprüche, wobei die Modulzeit unter Verwendung von dem Modul (1) empfangener Synchronisierungsnachrichten gemäß einem Synchronisierungsprotokoll mit der Systemzeit (T) synchronisiert wird.

5. Verfahren nach Anspruch 4, wobei das Synchronisierungsprotokoll das Precision Time Protocol ist.

6. Verfahren nach Anspruch 4, wobei das Synchronisierungsprotokoll das Network Time Protocol ist.

7. Verfahren nach einem der vorhergehenden Ansprüche, wobei das Analogsignal (S) von einer Abtasteinheit (7) abgetastet wird, die einen mittels einer Taktnachführungseinheit (9) von der Modulzeit abgeleiteten Taktgeber aufweist.

8. Verfahren nach einem der vorhergehenden Ansprüche, wobei ein Zeitabstand zwischen dem Empfangen je zweier aufeinander Meldesignale (M) durch den Prozessor (5) erfasst wird und auf einen Fehler des Moduls (1) geschlossen wird, wenn einer dieser Zeitabstände größer oder kleiner als ein vorgegebener Zeitschwellenwert ist.

9. Verfahren nach einem der vorhergehenden Ansprüche, wobei eine Reaktion ausgegeben wird, wenn auf einen Fehler des Moduls (1) geschlossen wird.

10. Modul (1) zur Abtastung eines Analogsignals (S) mit einer vorgegebenen Abtastrate, das Modul (1) umfassend
- eine Synchronisierungseinheit (3), die eingerichtet ist, eine Modulzeit wiederholt mit einer Systemzeit (T) zu synchronisieren,
- einen Prozessor (5), der eingerichtet ist, zu bezogen auf die Modulzeit äquidistanten Modulzeitpunkten jeweils ein Prozessorsignal (P) zu generieren, so dass die Differenz je zweier aufeinander folgender Modulzeitpunkte eine konstante Modulzeitdifferenz ist,
- eine Abtasteinheit (7), die einen mittels einer Taktnachführungseinheit (9) von der Modulzeit abgeleiteten Taktgeber aufweist und eingerichtet ist, das Analogsignal (S) gemäß der Abtastrate abzutasten und die Fertigstellung jeder Abtastung des Analogsignals (S) dem Prozessor (5) durch ein Meldesignal (M) zu melden,
- eine Zeitmesseinheit (11), die eingerichtet ist, für Prozessorsignale (P) jeweils eine Signaldifferenzzeitdauer zu messen, die ein Zeitabstand zwischen der Generierung des Prozessorsignals (P) und dem nächsten auf die Generierung des Prozessorsignals (P) folgenden Empfang eines Meldesignals (M) durch den Prozessor (5) ist, und
- eine Auswerteeinheit (13), die eingerichtet ist, eine einmalig für ein Prozessorsignal (P) gemessene Signaldifferenzzeitdauer als eine Referenzzeitdauer zu speichern und für jedes Prozessorsignal (P), das auf das für die Messung der Referenzzeitdauer verwendete Prozessorsignal (P) folgt, die gemessene Signaldifferenzzeitdauer mit der Referenzzeitdauer zu vergleichen und auf einen Fehler des Moduls (1) zu schließen, wenn die gemessene Signaldifferenzzeitdauer um mehr als die Toleranzzeitdauer von der Referenzzeitdauer abweicht.
